# EUROPEAN PATENT SPECIFICATION

(11) **EP 2 587 514 B1**
(45) Date of publication and mention of the grant of the patent: **18.06.2014**
(21) Application number: 13151675.9
(22) Date of filing: 25.04.2006
(51) Int. Cl.: H01J 3/02, H01J 1/304, H01L 51/00

(54) **Nanostructure-based electron beam writer**
Nanostrukturbasierter Elektronenstrahlschreiber
Enregistreur de faisceau d'électrons à base de nanostructures

(30) Priority: 25.04.2005 SE 0500926; 26.08.2005 SE 0501888; 10.02.2006 US 772449 P
(43) Date of publication of application: 01.05.2013
(62) Divisional of application: 06733343.5
(73) Proprietor: Smoltek AB, 417 55 Göteborg (SE)
(72) Inventor: Kabir, Mohammad Shafiqul, 412 61 GÖTEBORG (SE)
(74) Representative: Kransell & Wennborg KB

(56) References cited:
- US-A1- 2002 185 949
- LEE S W ET AL: "A Three-Terminal Carbon Nanorelay", NANO LETTERS, ACS, WASHINGTON DC, USA, vol. 4, no. 10, 8 April 2004 (2004-04-08), pages 2027-2030, XP002394788,
- KABIR M S ET AL: "Plasma-enhanced chemical vapour deposition growth of carbon nanotubes on different metal underlayers", NANOTECHNOLOGY, IOP, BRISTOL, GB, vol. 16, no. 4, 1 April 2005 (2005-04-01), pages 458-466, XP020090998, ISSN: 0957-4484
- TEO K B K ET AL: "Plasma enhanced chemical vapour deposition carbon nanotubes/nanofibres - how uniform do they grow?", NANOTECHNOLOGY, INSTITUTE OF PHYSICS PUBLISHING, BRISTOL, GB, vol. 14, no. 2, 1 February 2003 (2003-02-01), pages 204-211, XP020067488, ISSN: 0957-4484

## Description

### FIELD OF THE INVENTION

The present invention generally relates to nanostructures and methods for their growth. The present invention more particularly relates to methods of controlling the growth of nanostructures such as carbon nanofibers which enables manufacture of electron emission based devices such as electron beam writers and field emission displays.

### BACKGROUND

Relentless efforts at miniaturization are bringing traditional CMOS devices to the limit where the device characteristics are governed by quantum phenomena; in such regimes, perfect control is impossible to achieve. This has engendered a need for finding alternative new materials to fabricate devices that will possess at least the same or even better performance than existing CMOS devices but with greater control.

The miniaturization of CMOS devices has hitherto been governed by a trend - often called Moore's law- in which electronic components shrink in size by half every 30 months. The International Technology Roadmap for Semiconductors (ITRS) has established a projected growth curve according to this model. The demands for speed, high integration level, high performance and low production costs attendant on such a rate of progress are very stringent. Consequently, the problems associated with the physical and electrical characteristics of traditional materials used for making devices have escalated. Hence there is a need to search for alternative solutions to the problems that will ultimately impede the progress of silicon technology in the immediate future. This means that devising innovative material and process solutions is critical to sustaining the projected rate of growth.

The choice of new materials is however limited by factors such as compatibility with existing production methods, reproducibility of manufacture and cost. Some problems that existing technology materials have faced are as follows.

High power consumption due to leakage current: currently, the device performance is degraded due to high leakage current through gate oxide (which is very thin). This in turn increases the leakage current in the off state, and hence increases power consumption, which in turn reduces the life time of a battery.

Poor performance of Cu interconnects: due to its low resistivity, copper is used for making interconnects that are used for connecting various components to one another, as well as devices and circuits with the outside world. Due to the dramatic reduction in the size of the components, interconnects based on copper material are now showing poor performance in terms of current carrying capacity and lifetime of the wires. This in turn reduces the lifetime of a processor. No solution currently exists for interconnects that will efficiently connect the devices in a circuit with those outside of the circuit, in time to meet the projected demand for current density over the next several years.

Demand for high aspect ratio structures: today the aspect ratio of contact holes for interconnects in DRAM staked capacitors has reached 12:1 and is expected to increase to 23:1 by the year 2016. Creating such high aspect ratio contacts with straight walls poses substantial technological challenges, not least because void-free filling with metals (also known as vias) of such high aspect ratio features is extremely difficult.

High heat dissipation: modem microprocessors generate inordinate amounts of heat. Heat dissipation has been increasing steadily as the transistor count and clock frequency of computer processors has increased. In particular, for example, copper interconnects of the sizes required for current and future devices generate so much heat that their electrical resistance is increased, thereby leading to a decreased capacity to carry current. However a practical solution for cooling of such systems which will not eventually exceed the power budget for processors has yet to be found.

In short, for all these reasons, it has become necessary to search for alternative materials and processing technology.

Carbon nanostructures, including carbon nanotubes (CNTs) and nanofibers, are considered to be some of the most promising candidates for future developments in nanoelectronics, nano-electromechanical systems (NEMS), sensors, contact electrodes, nanophotonics, and nano-biotechnology. This is due principally to their one dimensional nature, and their unique electrical, optical and mechanical properties. In contrast to the fullerenes, such as C60 and C70, whose principal chemistry is based on attaching specific functionalities thereby giving rise to specific properties, CNTs offer an almost limitless amount of variation through design and manufacture of tubes of different diameters, pitches, and lengths. Furthermore, whereas the fullerenes offer the possibility of making a variety of discrete molecules with numerous specific properties, carbon nanotubes provide the possibility to make molecular-scale components that have excellent electrical and thermal conductivity, and strength. (See, *e.g., Nanoelectronics and Information Technology,* R. Waser (Ed.), Wiley-VCR, 2003, at chapter 19.)

Carbon nanotubes and carbon nanofibers have been considered for both active devices and as interconnect technology at least because their electrical and thermal properties and their strength. For example, the high electron mobility of carbon nanotubes (79,000 cm2/Vs) surpasses that of state-of-the-art MOSFET devices (see, *e.g*., Durkop, T., *et al., Nano Letters,* 4(1), 35, (2004)). Furthermore, the extremely high current carrying capacity of carbon nanotubes (1010 A/cm2) (see, *e.g*., Wei, B. Q., *et al., Appl. Phys. Lett.,* 79(8), 1172, (2001)), when compared with copper interconnects (∼ 106A/cm2), means that carbon nanotubes potentially possess the solution to the severe problems for interconnects projected in ITRS.

The anisotropic thermal conductivity of nanotubes/nanofibers (6,000 W/Km) (see, *e.g*., Roenlien, W., et al., IEEE Trans. Compon. and Packaging Tech., 27(4),629, (2004)) is also exceptionally promising for solving problems of heat dissipation.

Finally, the high E-modulus (representing the strength of a material) of individual nanotubes (as high as 1 TPa) has made them a good choice for both composite materials and for nanoelectromechanical devices.

In general, it is highly desirable to fabricate electronic devices that are compatible with existing complementary metal oxide semiconductor (CMOS) fabrication techniques. A prerequisite for exploring CNTs in an industrial process is to be able to control mass production of devices with high reproducibility. Due to high purity and high yield, chemical vapor deposition (CVD) is a popular and advantageous growth method that offers the potential to grow nanotubes at an exact location with control over their length, diameter, shape and orientation.

Hence for many electronic, nanoelectromechanical systems and interconnect applications the integration possibilities of carbon nanostructures into existing CMOS-based electronic industrial manufacturing processes is expected to be a ground breaking technological breakthrough. However, there are many engineering and materials issues inherent to CMOS compatible device fabrication processes that need to be addressed before such integration can take place. Solutions to these issues have so far been long-awaited.

For instance, there are problems related to growth of nanostructures. Although numerous techniques have been developed and demonstrated to produce carbon based nanostructures, all possess drawbacks regarding mass production and integration into existing industry manufacturing processes. Prominent drawbacks are: (a) control over predictable morphology with either semiconducting or metallic properties, (b) precise localization of the grown individual structures, and (c) predictable electrical properties at the interface between the grown nanostructures and the substrate. There is no known single solution to solve all the aforementioned drawbacks. The most prominent techniques for synthesizing carbon nanostructures include arc discharge (see, *e.g*., lijima, S., Nature, 354, 56, (1991); and Kratschmer, W.; Lamb, L. D.; Fostiropoulos, K.; Huffman, D. R., Nature, 347, 354, (1990)), laser vaporization (see, *e.g*., Kroto, H. W.; Heath, J. R.; O'Brien, S. C.; Curl, R. F.; Smalley, R. E. Nature, 318, 162, (1985)), catalytic chemical-vapor deposition (CCVD), also referred to as CVD, (Cassell, A. M.; Raymakers, J. A.; Jing, K.; Hongjie, D.,J Phys. Chern. B, 103, (31), (1999)), and catalytic plasma enhanced chemical-vapor deposition (C-PECVD) (Cassell, A. M.; Qi, Y.; Cruden, B. A.; Jun, L.; Sarrazin, P. C.; Hou Tee, N.; Jie, H.; Meyyappan, M., Nanotechnology, 15(1),9, (2004); and Meyyappan, M.; Delzeit, L.; Cassell, A.; Hash, D., Plasma Sources, Science and Technology, 12(2),205, (2003)). Due to high purity and high yield, chemical vapor deposition (CVD) is a popular and advantageous growth method, and indeed, among all of the known growth techniques, CMOS compatibility has been demonstrated only for the CCVD method. (See, Tseng, *et al.* (Tseng, Y.-C.; Xuan, P.; Javey, A.; Malloy, R.; Wang, Q.; Bokor, J.; Dai, H. Nano Lett. 4(1), 123-127, (2004)) where a monolithic integration of nanotube devices was performed on n-channel semiconductor (NMOS) circuitry.)

There are specific problems related to control of the properties of grown materials. Even though numerous different alternative growth methods exist for growing carbon nanostructures, controlling the interface properties between the nanostructures and the substrates, the body of the nanostructures, and the tip of the nanostructures are not yet demonstrated to be well controlled by utilizing a single method of growth.

CVD typically employs a metal catalyst to facilitate carbon nanostructure growth. The main roles of the catalyst are to break bonds in the carbon carrying species and to absorb carbon at its surface and to reform graphitic planes through diffusion of carbon through or around an interface (see, *e.g*., Kim, M. S.; Rodriguez, N. M.; Balcer, R. T. K., Journal of Catalysis, 131, (1), 60, (1991); and Melechko, A. V.; Merkulov, V. L; McKnight, T. E.; Guillom, M. A.; Klein, K. L.; Lowndes, D. H.; Simpson, M. L.,J. App. Phys., 97(4), 41301, (2005).

However, the growth of nanotubes is usually carried out on silicon or other semiconducting substrates. Growth from such metal catalysts on conducting metal substrates or metal underlayers is almost lacking. This is because it has been found that it is hard to make a good contact between a growing nanostructure and a conducting substrate with good quality grown nanostructures in terms of control over diameter, length and morphology. Nevertheless, for making CMOS-compatible structures, it is necessary to use a conducting substrate. In particular, this is because a metal substrate, or base layer, acts as bottom electrode for electrical connection to the nanostructures.

Nevertheless, growth of nanostructures on CMOS compatible conducting substrates has proved to be far from trivial, at least because different metals require different conditions, and also because it has proven difficult to control the properties of the nanostructures grown on such substrates with predictable control over diameter, length and morphology of the grown structures and with predictable interface properties between the nanostructures and the substrate.

A method for producing arrays of carbon nanotubes on a metal underlayer, with a silicon buffer layer between the metal underlayer and a catalyst layer, is described in U.S. Patent Application Publication No. 2004/0101468 by Liu et al*.* According to Liu, the buffer layer prevents catalyst from diffusing into the substrate and also prevents the metal underlayer from reacting with carbon source gas to, undesirably, form amorphous carbon instead of carbon nanostructures. In Liu, the process involves, inconveniently, annealing the substrate in air for 10 hours at 300-400 °C to form catalyst particles, via oxidation of the catalyst layer, prior to forming the nanostructures. Each catalyst particle acts as a seed to promote growth of a nanostructure. The method of Liu, however, does not permit control of the composition or properties of the nanostructures and the nanotubes produced are curved and disorganized.

An additional goal is fabrication of carbon based nano-electro mechanical structures (NEMS). Extensive theoretical analysis on two- terminal and three-terminal carbon based NEMS (C-NEMS) structures were performed by Dequesnes et al. (Dequesnes, M.; Rotkin, S.V.; Alum, N. R., Nanotechnology, 13(1), 120, (2002» and Kinaret et al. (Kinaret, J. M.; Nord, T.; Viefers, S., Applied Physics Letters, 82(8), 1287, (2003» respectively. The model developed by Kinaret *et al.* for three-terminal NEMS device consists of a conducting carbon nanotube (CNT) placed on a terraced Si substrate and connected to a fixed source electrode which they have called it "nanorelay." Recently Lee *et al.* (Lee, S. W. L., et al., Nano Letters, 4(10), 2027, (2004» have demonstrated the characteristics of such three terminal nanorelay structures experimentally. However, the experimental approach by Lee *et al.* for fabricating such devices is time consuming and the technology is heavily dependent on the sonicated CNF solutions which usually do not possess any control over the length and the diameter of the CNF: the functional part of the device. Therefore, it is desirable to develop a technology for fabricating such structures with predictable behavior.

### SUMMARY OF THE INVENTION

According to the present invention, there is provided an electron beam writer, comprising: a support; an insulating layer on the support; a third layer of material on the insulating layer, arranged to form a cavity; a metal electrode on the insulating layer, in the cavity; a nanostructure built upon the metal electrode; and a first electrode layer deposited on the third layer of material.

### BRIEF DESCRIPTION OFTHE DRAWINGS

FIG. 1 shows a schematic of a carbon nanofiber.
FIG. 2 shows a flow-chart of an overall process according to the present invention.
FIGS. 3A and 3B show various configurations of the present invention.
FIG. 4 shows a multilayer stack between a metal layer and a nanostructure, and having various segments of different functionalities.
FIG. 5 shows a step in creation of an individual nanostructure.
FIG. 6 shows an individual nanostructure with a single layer between the nanostructure body and a metal substrate.
FIG. 7 shows an individual nanostructure.
FIG. 8 shows an individual nanostructure having a multilayer stack.
FIG. 9 shows an embodiment of a nanostructure.
FIG. 10 shows an intermediate stage in a process of making a nanostructure.
FIG. 11 shows an example of growth of a nanostructure.
FIGs. 12A - 12C show various embodiments of an electron-beam emitter using nanostructures according to the present invention.
FIGs. 13A - 13D show various embodiments of electrode configurations in an electron-beam writer using nanostructures according to the present invention.
FIG. 14 shows an electron-beam writer configured to write on a substrate.
FIG. 15 shows a horizontal configuration of an electron-beam writer.
FIG. 16 shows an exemplary electron-beam writer using a nanostructure.

### DETAILED DESCRIPTION

### Overview

The present invention is directed to processes for making nanostructures, singly, or in arrays, on a conducting substrate. In particular, the processes of the present invention permit choices of material, and sequences of materials, lying between the substrate and the base of the nanostructure, to control various properties of the interface between the nanostructure and the substrate, properties of the body of the nanostructure, and the composition of the tip of the nanostructure. It is preferable that the nanostructures form columns that grow perpendicularly, or almost perpendicularly up from the substrate. However, this does not exclude the possibility to grow the nanostructures at other angles from the substrate such as on the substrate, (i.e.. , parallel to the substrate), or at an inclined angle other than 90°.

Accordingly, the present invention relates to: a method of growing/depositing nanostructures utilizing existing CMOS technology; a method of growing nanostructures on CMOS compatible conducting substrates and glass substrate and flexible polymer substrates used in areas that utilize thin film technology; a method to control the chemical interactions and hence controlling the end chemical compounds in the nanostructures; and a method to control the chemical reactions by having multilayer material stacks consisting of at least one intermediate layer between the substrate and a catalyst layer, wherein the intermediate layer is not of the same material as either the catalyst layer or the conducting substrate.

The present invention therefore provides a method for integrating nanostructures into CMOS technology and to achieve downscaling, higher component density and new functionality in, *e.g*., integrated circuits.

The ability to grow nanostructures on different metal underlayers (metal substrates) is important for several other reasons, including the fact that the identity of the metal is an additional parameter that can be tuned to control the parameters of grown nanostructures such as height, diameter, density, *etc*., and because different metal work functions can be exploited to control the height of the Schottky barrier between the metal underlayers and the nanostructures, thus permitting control over device functionality.

By controlling the choice of material stacks and the sequence of different materials, the layers in a stack can be used to control properties of the grown/deposited nanostructures.

In particular, by varying the materials and sequence of the materials the properties of the following can be controlled: the interface between the nanostructure and the substrate can be controlled to have properties that include, but are not limited to, Ohmic barriers, Schottky contacts, or controllable tunneling barrier(s); the body of the nanostructures; and the chemical composition of the tip of the nanostructures.

By controlling the properties of these three parts (the interface, the body, and the tip), different structures, components and devices can be fabricated which can be used in different applications. By controlling the properties of these three parts in combination with different structures, components and devices, different functionality can be achieved. For example, the tip of the nanostructure can be tailored to have a particular chemical property, or composition. Such tailoring permits the tip of the nanostructure to be functionalized in different ways.

### Nanostructures

The nanostructures formed by the methods of the present invention are preferably made predominantly from carbon. However, other chemical compositions are consistent with the methods of the present invention and are further described herein.

Nanostructures as referred to herein, encompass, carbon nanotubes, nanotubes generally, carbon nanostructures, other related structures such as nanofibers, nanoropes, and nanowires, as those terms are understood in the art.

By carbon nanotube (CNT), is meant a hollow cylindrical molecular structure, composed principally of covalently bonded *Sp2*-hybridized carbon atoms in a continuous network of edge-fused 6-membered rings, and having a diameter of from about 0.5 to about 50 nm. Typically a nanotube is capped at one or both ends by a hemispherical carbon cap having fused sand 6-membered rings of carbon atoms, though the nanotubes of the present invention are not necessarily capped. Carbon nanotubes may be, in length, from a few nanometers, to tens or hundreds of microns, to several centimeters.

The typical make-up of a CNT is analogous to a sheet of graphitic carbon wrapped on itself to form a closed surface, without any dangling bonds. Thus, CNT's typically consist of a closed network of 6-membered carbon rings, fused together at their edges. Most CNT's have a chirality that can be envisaged as arising if a sheet of graphitic carbon is sheared slightly before it is bended back on itself to form a tube. CNT's of any chirality may be formed by the present invention. It is also consistent with the present invention, however, that the carbon nanotubes also may have a number of 5-membered rings, fused amongst the 6-membered rings, as is found in, for example, the related "fullerene" molecules, and where necessary to, for example, relieve strain or introduce a kink. Carbon nanotubes have electrical properties that range from metallic to semiconductors, depending at least in part on their chirality.

By suitable choice of materials lying in between the substrate and the base of the nanostructure, and their sequence, the morphology of the nanostructure that is formed can be tailored. Such nanostructures include, but are not limited to, nanotubes, both single-walled and multi-walled, nanofibers, or a nanowire. Such tailoring can arise from, *e.g*., the choice of texture of the catalyst layer that is positioned between the substrate and the nanostructure.

Carbon nanotubes made by the methods of the present invention may be of the single-walled variety (SWCNT's), having a cylinder formed from a single layer of carbon atoms such as a single layer of graphitic carbon, or of the multi-walled variety (MWCNT's), having two or more concentrically arranged sheaths of single layers. MWCNT's may consist of either concentric cylinders of SWCNT's or stacks of frusto-conical shaped single-walled structures.

A carbon nanofiber (CNF) is typically not hollow, but has a "herring-bone" or "bamboo"-like structure in which discrete segments of carbon fuse together one after another. The typical diameters ranges from 5 nm to 100 nm. A conical segment of catalyst containing material is typically found at the tip of such a nanofiber. Carbon nanofibers are thus not crystalline and have different electrical conductivity from carbon nanotubes. Carbon nanofibers are effective interconnects in electronic circuits because they support electric current densities of around 1010 A/cm2. Carbon nanofibers thus have a higher atomic density, given by numbers of carbon atoms per unit volume of fiber, than the, hollow, nanotubes.

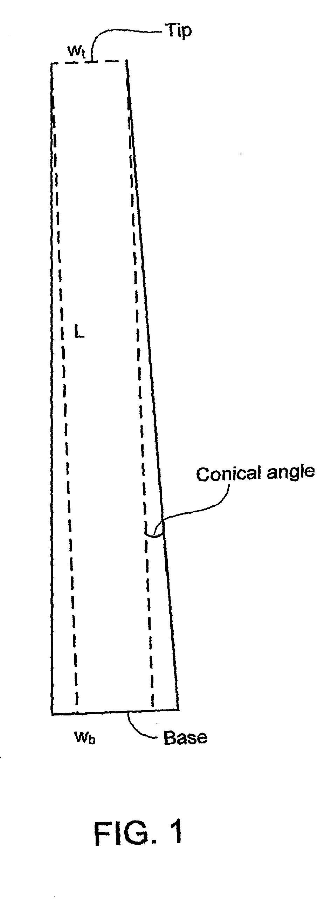

Carbon nanofibers made according to the present invention also can be generally straight, and have a conical angle < 2°, see FIG. 1, where the conical angle definition assumes that the base of the nanostructure is broader than its tip.

A carbon nanorope has a diameter in the range 20-200 nm, and thus is typically larger in diameter than a carbon nanotube. A carbon nanorope is typically constructed by intertwining several nanotubes in a manner akin to the way in which a macroscopic rope consists of several strands of fiber bundled together. The various nanotubes in a nanorope may be twisted around one another or may line up substantially parallel to one another; the individual nanotubes are held together principally by van der Waals forces. Such forces, although individually weaker than a covalent bond between a pair of atoms, are in the aggregate very strong when summed over all of the pairs of atoms in adjacent tubes

### The Interface

According to the present invention, by suitable choice of materials and their sequence, the interface between the base of the nanostructure and the substrate can be chosen to have various electrical properties. For example, it can be chosen to be an ohmic contact, a Schottky barrier, or a controllable tunnel barrier.

An Ohmic contact is a metal-semiconductor contact with very low resistance, independent of applied voltage (and which may therefore be represented by a constant resistance). The current flowing through an ohmic contact is in direct proportion to an applied voltage across the contact as would be the case for an ohmic conductor such as a metal. To form an ohmic contact, the metal and semiconductor must be selected such that there is no potential barrier formed at the interface (or so that the potential barrier is so thin that charge carriers can readily tunnel through it).

A Schottky barrier is a semiconductor-metal interface in which the metal-semiconductor contact is used to form a potential barrier.

A tunnel barrier is a barrier through which a charge carrier, such as an electron or a hole, can tunnel.

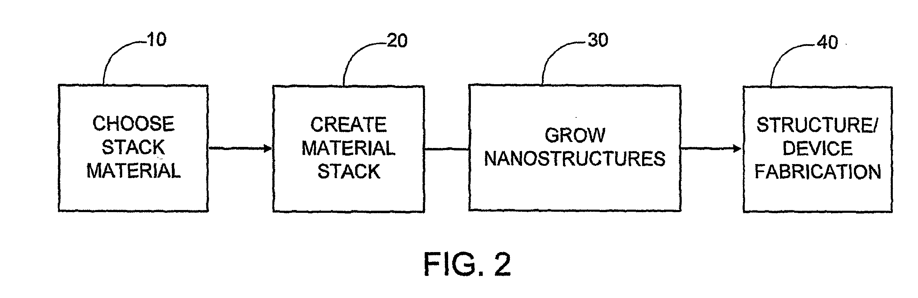

FIG. 2 is a flow-chart that describes in overview a process of making nanostructures on a substrate according to the present invention. First, one chooses a stack material, step 10. Then, a stack is created from the chosen materials, step 20, for example by deposition, sputtering or evaporation on to a substrate. Then, nanostructures are grown on the stack, step 30, for example in a growth/deposition chamber. Finally, the structure is incorporated into a device, by one or more additional fabrication techniques, step 40.

Chemical Vapor Deposition (CVD) is the preferred method for growth of nanostructures according to the present invention. However, there are different kinds of CVD methods that can be used, *e.g*., thermal CVD, PECVD, RPECVD, MOCVD (metallo-organic CVD), etc. It would be understood by one of ordinary skill in the art, that other variants of CVD are compatible with the present invention and that the practice of the present invention is not limited to those methods previously referenced.

It is preferable that the substrate for use with the present invention is a conducting substrate. Accordingly, it is preferably a metal, or a metal alloy substrate. By the methods of the present invention, step 10 can influence the properties of the nanostructures that are grown. In particular, the nature and properties of the nanostructure are governed by the nature and extent of interdiffusion of the layers between the substrate and the nanostructure. Permitting interdiffusion can control the diameter and morphology of the nanostructure, the number of nanotubes that grow per unit area of substrate, as well as the density of a nanostructure, and the electrical properties of the interface. On the other hand, using materials that impede diffusion between the substrate and the carbon nanostructure can control chemical interactions with the interface materials on both sides of the material, as well as the electrical properties of the interface.

The layers of materials in the stack can be deposited as a continuous film in the case where it is desired to grow many, *e.g*., an array of several hundreds or many thousands of, nanostructures on a single substrate. A patterned film can also be used to control the properties but in specific localized areas, leading to fabrication of individual devices. The deposited film thickness may vary from 0.5 nm to more than 100 nm, *e.g*., as much as 150 nm, 200nm, or even 500 nm, depending on the substrate underneath. Preferably, however, the thickness is from 1 to 10 nm, and even more preferably, from 5 to 50 nm.

The nanostructures of the present invention can also be grown individually rather than as a dense "forest". For example, such nanostructures may be discrete carbon fibers. This is the case where catalyst layer and sizes are defined by lithography for example. For the case where a continuous film (in the form of stripes and squares larger than 100 nm X 100 nm) is used, more densely packed structures are possible (approximately 15 nm spacing between two adjacent nanostructures is preferred). In such continuous film configurations, the packing density and resulting diameter of the nanostructures can however be controlled by the choice of support layer.

In particular, the body of the nanostructures can be designed to be structures that include: hollow with electrical properties such as semiconducting or metallic; not hollow with different electrical properties (mainly metallic); hollow with different mechanical properties; and not hollow with different mechanical properties.

### Controlling Nanostructure properties

The present invention encompasses nanostructures grown from substrates, and interface layers situated therebetween, having the following characteristics. The substrate is preferably a metal layer, which may be disposed on a support. The support is typically a wafer of silicon or other semiconducting material, glass, or suitable flexible polymer used in thin film technology. The metal is preferably selected from the group consisting of molybdenum, tungsten, platinum, palladium, and tantalum. The thickness of the metal layer is preferably in the range 1 nm to 1 µm and even more preferably in the range 1 nm to 50 nm. The metal layer is preferably deposited by anyone of several methods known in the art, including but not limited to: evaporative methods such as thermal or vacuum evaporation, molecular beam epitaxy, and electron-beam evaporation; glow-discharge methods such as any of the several forms of sputtering known in the art, and plasma processes such as plasma-enhanced CVD; and chemical processes including gas-phase processes such as chemical vapor deposition, and ion implantation, and liquid-phase processes such as electroplating, and liquid phase epitaxy. Examples of deposition technologies are found in Handbook of Thin Film Deposition, K. Seshan, Ed., Second Edition, (William Andrew, In., 2002).

The interface layers, also called intermediate layers or an intermediate layer, comprise one or more layers, in sequence, disposed upon the substrate. On top of the interface layers is a layer of catalyst. The nanostructure is grown from on top of the catalyst layer.

The interface layers may consist simply of a single layer of material. In this circumstance, the single layer is preferably silicon or germanium. The layers can be deposited in the form of amorphous or crystalline by techniques such as evaporation, or sputtering. The preferable thickness ranges from 1 urn to 1 /Im and even more preferably in the range 1 nm to 50 nm.

The interface layers may comprise several layers of different materials and may be, arbitrarily, classified according to function. For example, the layers in the vicinity of the substrate are characterized as layers that influence the electrical properties of the interface. The layers in the vicinity of the catalyst are characterized as layers that influence the composition and properties such as electrical/mechanical properties of the nanostructure.

Various configurations of interface layers are compatible with the present invention. For example, a sequence of up to 3 layers may be deposited on the substrate, for the purpose of controlling the electrical properties of the interface. Such configurations include, but are not limited to: a sequence of insulator, conductor or semiconductor, and insulator; a sequence of insulator adjacent to the substrate, and a semiconducting layer; a sequence of semiconductor, insulator, semiconductor; a sequence of two insulating barrier layers adjacent to the substrate, and a semiconductor; a single layer of a metal that is different from the metal of the substrate; and a sequence of a metal that is different from the metal of the substrate, and a semiconducting layer. In such configurations, the insulator may be selected from the group consisting of: SiOx, Al203, ZrOx, HfOx, SiNx, Al203, Ta2O5, TiO2, and ITO. The semiconductor may be silicon or germanium. The metal, where present, may be palladium, platinum molybdenum or tungsten. Where two layers of the same character are present, *e.g*., two semiconducting layers, it is not necessary that the layers have the same composition as one another.

The uppermost layer of the foregoing interface layers may itself abut against the catalyst layer. This is particularly the case where the uppermost layer is a semiconductor such as silicon or germanium. However, it is additionally possible for the foregoing interface layers to have disposed upon them a further layer or sequence of layers that lies between them and the catalyst layer. Such additional, or second, interface layers are thought of as controlling the properties and composition of the nanostructure. The second interface layers may be a pair of layers, such as a metal layer and on top thereof a semiconductor layer adjacent to the catalyst layer. Alternatively, the second interface layers may simply consist of a single layer of semiconductor. The metal layer, where present in the second interface layers, is preferably selected from the group consisting of tungsten, molybdenum, palladium, and platinum. The semiconducting layer in the second interface layers is preferably silicon or germanium.

The catalyst layer is typically a layer of metal or metal alloy, and may contain very fine particles of metal or metal alloy instead of being a continuous film. The catalyst layer preferably comprises a metal selected from the group consisting of nickel, palladium, iron, nickel-chromium alloy containing nickel and chromium in any proportions, and molybdenum.

The invention is primarily focused on a multi-stack configuration of at least one material layer between the catalyst layer and the conducting substrate, wherein the material is not of the same kind as the catalyst and conducting substrate, and wherein the material controls the chemical reactions between the various layers. Thus, the growth of the nanostructures on different conducting substrates can be controlled. Thereby the morphology and properties of the grown structures as well as the tip materials of the grown structures can be controlled. The current invention can be extended to having several stacks of materials of different kinds (semiconducting, ferroelectric, magnetic, etc.) which can be used to control the properties at base/interface, body and the tip of the nanostructure. It is also possible that the nanostructure is grown upon a conducting layer which is itself deposited on a substrate that itself can be of any kind, such as conducting, insulating or semiconducting.

High-k dielectric materials are mainly used as gate materials for CMOS devices. In the present invention such materials are utilized in part in multi-layer stacks to define the properties of the grown nanostructure as well as to control the interface properties between the nanostructure and the conducting layer.

According to the methods of the present invention, the presence of two or more intermediate layers will influence the texture/crystallographic structures of each other and the final catalyst particles.

Accordingly, the present invention preferably includes a conducting layer, at least one intermediate layer directly on the conducting layer, at least one catalyst layer directly on the intermediate layer, and a nanostructure on the catalyst layer.

The substrate may be a disposed on a support commonly used in semiconductor processing, such as a silicon wafer, or oxidized silicon wafer. The support may alternatively be a glass or metal or thin flexible polymer film used in the thin film technology as substrate.

It is to be understood that the at least one intermediate layer is chosen to control various electrical properties of the interface between the substrate and the carbon nanostructure.

It is further to be understood that the choice of at least one catalyst layer controls various properties of the carbon nanostructure.

The grown nanostructures are preferably carbon-based materials such as carbon nanotubes (CNT), and carbon nanofibers (CNF). Carbon nanostructures form when the entire structure is placed in a mixture of carbon-containing gases. Preferred gases are hydrocarbons such as CH4, C2H2 and C2H4, and generally aliphatic hydrocarbons having 5 or fewer carbon atoms, of any level of saturation.

The nanostructures can also be of different semiconducting materials referred to as IIIV, or II-VI materials, such as InP, GaAs, AlGaAs, depending on the choice of catalyst and subsequent chemical chamber conditions used. Keeping all the other materials stack same as for a carbon nanostructure described herein, simply changing the catalyst type and or composition of gases can facilitate growth of these non-carbon nanostructures. Therefore without deviating from the other aspects of the invention described herein, a person of ordinary skill in the art can grow different kinds of solid state nanostructures. Examples of conditions for forming such nanostructures are as follows.

SiC nanostructures: chambers - MOCVD (metallo organic CVD); gas composition dichloromethylvinylsilane [CH2CHSi(CH3)Cl2]; catalyst - Ni; and temperature: 800-1200 °C.

Si nanostructures: chamber type - vapor-liquid-solid (VLS)/CVD; gas composition - SiH4, Si2H6; catalyst - Ni; and temperature 500 - 1000 °C.

InP/GaP nanostructures: chambers - MOCVD/CVD; gas composition- elemental indium and gallium with triphenyl phosphine, trimethyl-gallium and N2; catalyst; and temperature: 350-800°C.

GaN nanostructures: chambers - MOCVD (metallo organic CVD); gas/ composition elemental gallium and ammonia gas; catalyst - Ni; and temperature: 800 - 900 °C.

ZnO nanostructures: chambers - MOCVD/CVD; gas composition - oxidation of Zinc carrying elements; catalyst - Ni; temperature 30 - 700°C.

The grown nanostructures for materials other than carbon can be of the form of forests consisting of uniform structures covering the substrate area and/or arrays, or individual structures.

The choice of catalyst plays an important role because the growth of carbon nanostructures is ordinarily catalytically controlled. Since the crystallographic orientation of the catalysts partakes in defining the morphology of the nanostructure , it is expected to obtain different growth mechanisms from different types of catalysts. Besides catalyst crystallographic orientation, there are many other growth conditions that influence the structure formation, such as the mixture of gases, current density for the case when plasma density is controlled, voltage between the cathode and anode, temperature of the substrate, chamber pressure, etc. (see, *e*. g. , Kabir, M. S.; Morjan, R. E.; Nerushev, O. A.; Lundgren, P.; Bengtsson, S.; Enokson, P.; and Campbell, E. E. B., Nanotechnology 2005, (4), 458).

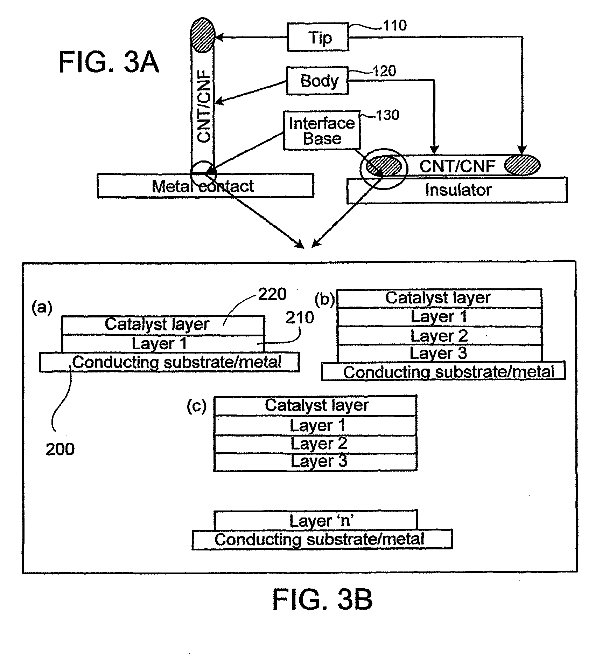

FIGs, 3A and 3B show an overview of various structures according to the invention. FIG. 3A shows how a carbon nanostructure having a tip 110, body 120 and a base 130, and made by processes described herein, can be positioned vertically on a metal substrate as in the left-hand side of FIG. 3A, or horizontally on an insulating substrate as in the right-hand side of FIG. 3A. Positioning on an insulating substrate will allow for further processing for making functional devices. The bottom substrate (not shown) underneath the insulating layer can be used as a bottom gate dielectric and the substrate underneath the oxide as bottom gate electrode to *e.g*., modulate the resistance of a semiconducting nanostructure. See FIG. 3B.

FIG. 3B shows various configurations of one or more intermediate layers 210 between a conducting substrate 200 and a catalyst layer 220. The invention proposes a platform comprising at least one material stack (denoted, *e.g*., layer 1) between the catalyst layer and the conducting substrate. The purpose of the multiple materials stacks (denoted, *e.g*., layer 1, layer 2, ... layer *n*) is to control the interface properties between the conducting substrate and the grown nanostructures (for example, ranging from Ohmic contact to Schottky barrier), the properties of the grown nanostructures (morphology, mechanical, and electrical properties), and the properties of the tip 110 of the grown nanostructures.

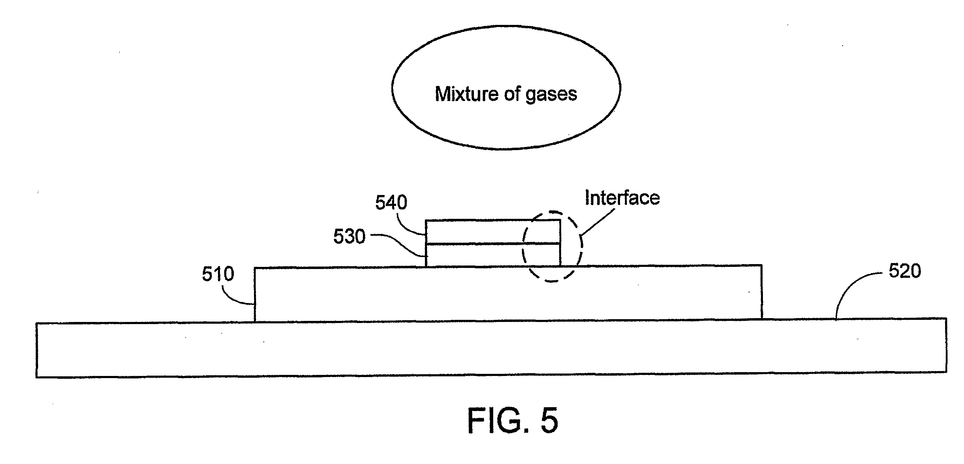

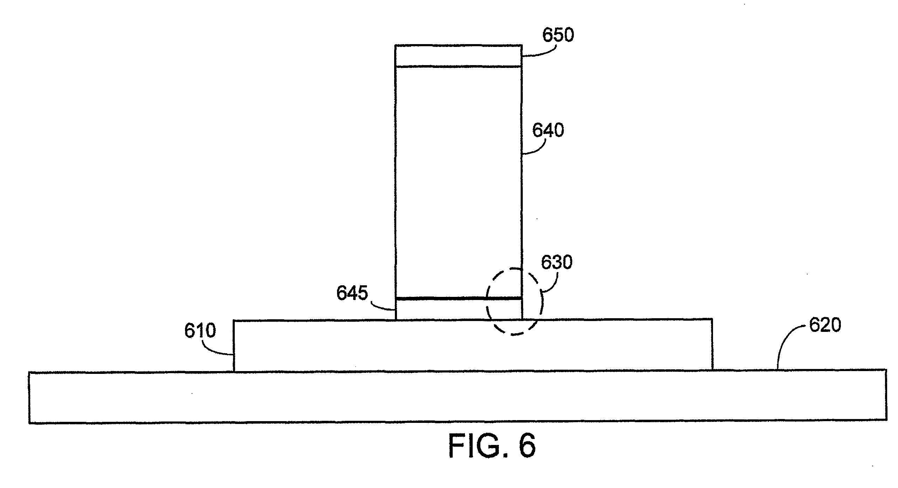

FIGs. 5 and 6 show embodiments of a device having a single intermediate layer. In FIG. 5, in another embodiment, a metal layer 510 is on a wafer 520; an intermediate layer of silicon 530 is on the metal layer; and a catalyst layer 540, typically Ni, or Fe, or others such as NiCr or, Pd, is on the intermediate layer. Together, layers 530 and 540 are referred to as the interface.

In FIG. 6, another typical individual nanostructure is shown. In this structure, a metal layer 610 is on a wafer 620; an interface 630 between the metal layer and a body of a nanostructure 640 is formed from an intermediate layer of semi-conducting material 645 such as silicon. The tip 650 of the nanostructure contains a mixture of materials, including principally catalyst that has diffused up the body of the nanostructure as the nanostructure has grown, and also some metal.

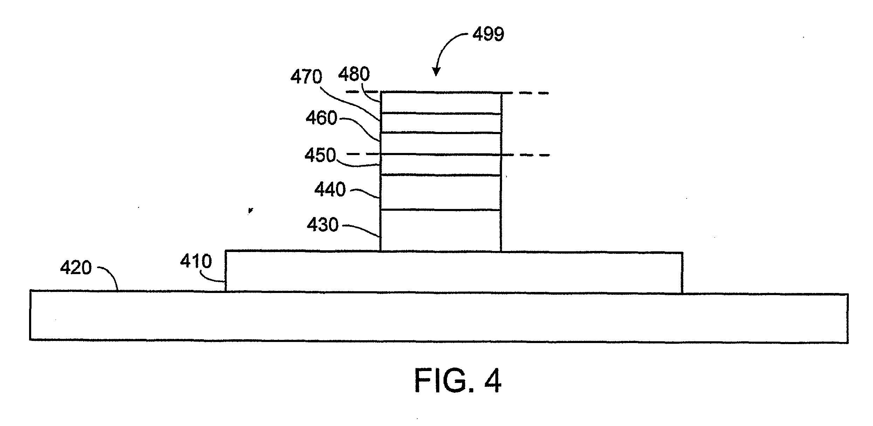

FIG. 4 shows a representative embodiment having a multilayer stack supporting a partially formed nanostructure 499. A metal layer 410 acts as a substrate, and is disposed on a support 420, *e.g*., a wafer of silicon. A 3-layer stack acts as an intermediate layer between the metal substrate and a second stack of catalytic layers and controls the electrical properties of the interface. The intermediate layer has, in order, starting with a layer in contact with the metal: a first control layer 430, of *e.g*., SiOx, or A1203; on top of the first control layer is a metal/semimetal layer 440, *e.g*., Ge; on top of the metal/semi-metal layer is a second control layer 450 of, *e.g*., ZrOx or HfOx or any other material with high *k* dielectric value such as SiNx, Ta2O5, Al2O3, and TiO2. The subscript 'x' in a chemical formula denotes a variable stoichiometry, usually controllably variable. The two control layers control diffusion from respectively the metal/semimetal layer into the substrate and into the catalyst stack The thickness and composition of the two control layers provide two variables with which such control may be achieved. The thickness for a single layer ranges from less than 10 nm to several hundreds of nanometer and the thickness of the total material stack ranges from less than 10 nm up to microns and above. Together, the first control, metal/semi-metal, and second control layers permit control of electrical properties of the interface between the metal and the carbon nanostructure. To obtain different electron/hole tunneling properties, it is a matter of choosing different oxides to give a variation of electrical tunneling properties and hence varying electrical properties of the interface between the nanostructure and the base substrate 410. Principally, such choices are determined by the dielectric constant of the control layer materials such as oxides.

Also referring to FIG. 4, a multilayer stack disposed on the second control layer controls properties of the carbon nanostructure that grows above it. In the example shown, adjacent to the second control layer is a first metal layer 460, *e.g*., tungsten, molybdenum, palladium, platinum; adjacent to the first metal layer is a silicon layer 470; and on top of the silicon layer is a second metal layer 480 composed of, *e.g*., nickel or palladium.

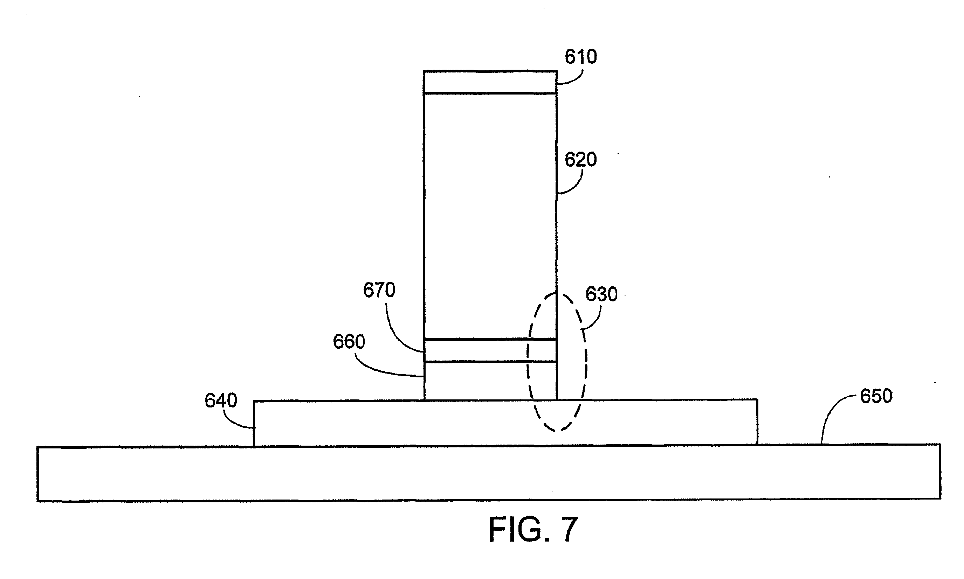

FIG. 7 shows another embodiment of a nanostructure having a tip 610, a body 620, and an interface 630. A metal layer 640 is disposed on a wafer 650 and consists of a metal selected from the group consisting of molybdenum, tungsten, platinum, tantalum, and palladium. A two layer interface 630 is on the metal layer 640 and has a first intermediate layer 660 of oxide, such as SiOx, ZrOx, HfOx, or TiOx; a second intermediate layer 670, composed of silicon, is disposed on the first intermediate layer and is in contact with the body of the nanostructure. The tip 610 of the nanostructure contains Ni, Fe, Mo, or Pd, or an alloy such as NiCr or a mixture of the materials found in the material stack. The metal content of the tip originates with a layer of catalyst (not shown in FIG. 7) that was situated between the uppermost intermediate layer and the bottom of the nanostructure.

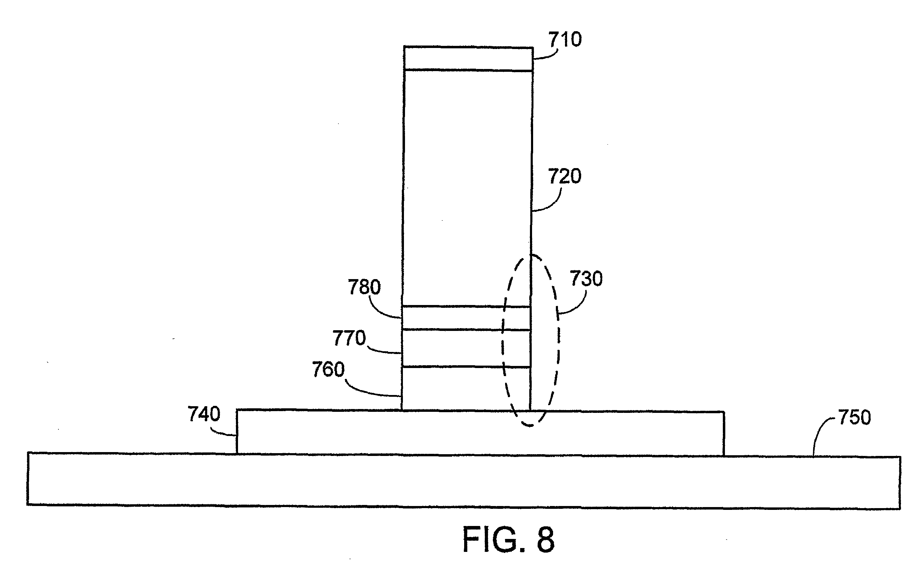

FIG. 8 shows another nanostructure having a tip 710, a body 720, and an interface 730 which comprises a multi-layer stack. A metal layer 740 is disposed on a wafer 750. A three-layer interface 730 is on the metal layer 740 and has a first intermediate layer 760 of semi-metal such as germanium; a second intermediate layer 770 of oxide, such as SiOx, ZrOx, HfOx, or TiOx; and a third intermediate layer 780, composed of silicon, which is in contact with the body of the nanostructure. The tip of the nanostructure contains Ni, Fe, Mo, or Pd, or an alloy such as NiCr or a mixture of the materials found in the interface.

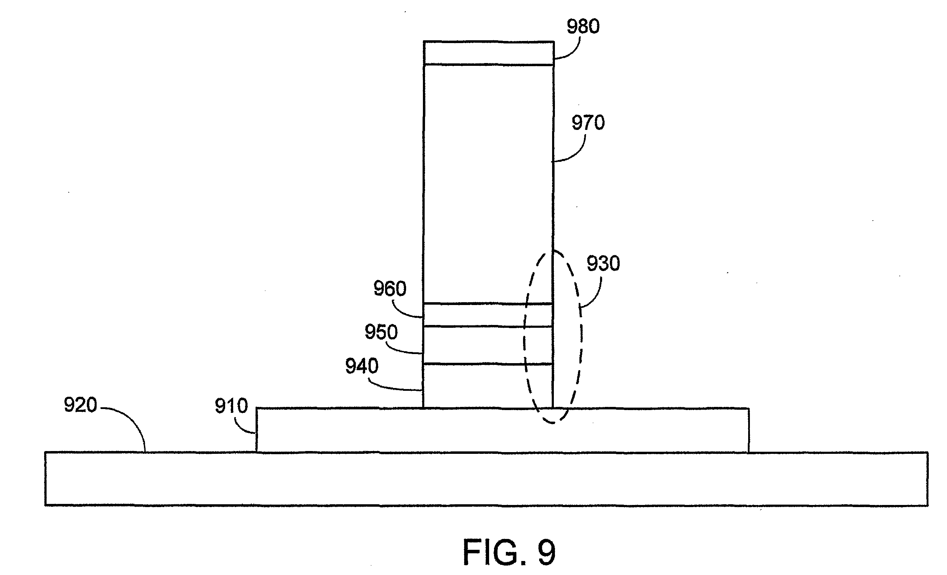

FIG. 9 shows another embodiment of a nanostructure: a metal layer 910 is disposed on a wafer 920; an interface 930 having three intermediate layers is disposed on the metal layer 910. The three intermediate layers, in sequence moving away from the metal, are: a second barrier layer 940, a first barrier layer 950 and a semiconducting layer 960, in contact with the body of the nanostructure 970. The first barrier layer can be used as a material diffusion barrier upwards/downwards, and the second barrier layer can be used as defining the electrical tunnel barrier. The body of the nanostructure can have electrical properties either as a semiconductor or a conductor. The tip 980 of the nanostructure contains catalyst.

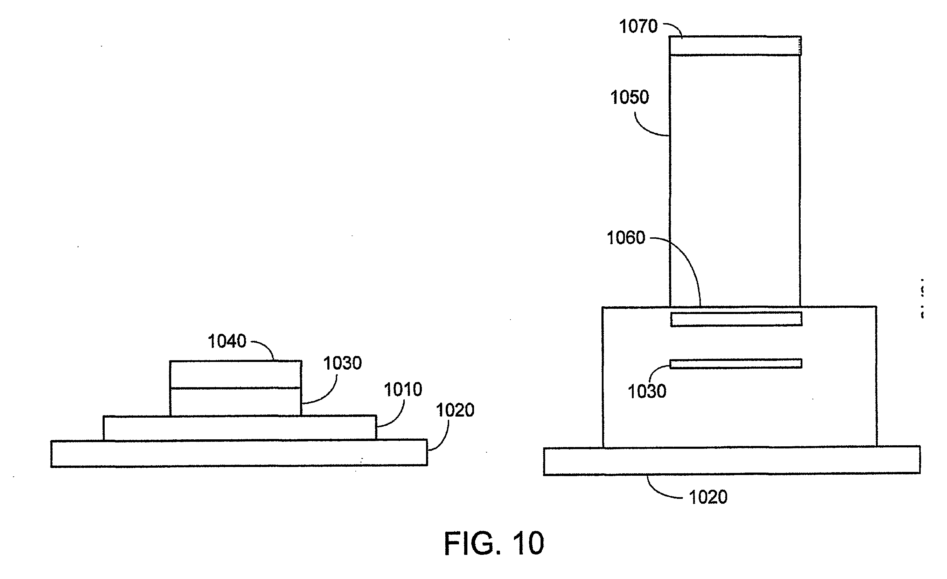

As is seen from FIGs. 6-9, catalyst diffuses into the body of the nanostructure during growth initiation This process is described in further detail in FIG. 10. In FIG. 10, a metal underlayer 1010 of a metal such as W, Mo, Pt, Pd,. is on a wafer 1020. An intermediate layer of a semiconducting material 1030 such as silicon or germanium, or a compound of III-V elements from the periodic table, is on the metal underlayer. A catalyst layer 1040 having a metal such as Ni, Fe, Co, or an alloy such as NiCr is on the intermediate layer.

A stage during growth of the nanostructure is shown in the right-hand panel of FIG. 10. An expanded view of the metal underlayer is shown. An interface 1060 between the metal underlayer and the body 1050 of the growing nanostructure contains an alloy of catalyst with metal underlayer, metal silicides, and the metal underlayer itself.

The intermediate layer 1030 is used to start the growth process. However it diffuses into the metal underlayers creating metal compounds such as metal-silicides if the intermediate layer is silicon, which function as Ohmic contacts with the metal underlayer. Accordingly the nanostructure is grown by direct contact with metal underlayer where no intermediate layer is present in between the initial catalyst and metal underlayer. A small portion of catalyst is present at the bottom. The tip consists of catalyst rich metal underlayer: a large portion of catalyst is present at the tip of the nanostructure together with a small portion of metal underlayer.

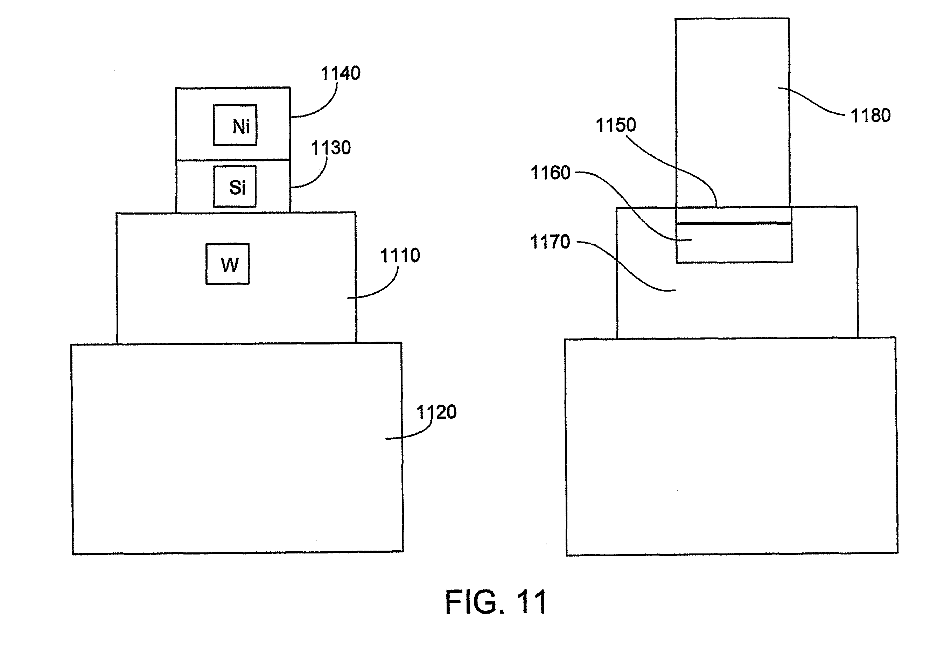

In FIG. 11, an embodiment of nanostructure growth uses a tungsten (W) metal underlayer 1110 on a wafer 1120. A stack having a layer of silicon 1130 on top of the metal underlayer, and a layer of nickel 1140 on top of the silicon is in contact with a growing nanostructure 1180. The material stack conditions before growth (FIG. 11, left hand panel) show discrete layers. The material stack conditions after growth (FIG. 11, right hand panel) show that interdiffusion amongst the layers has occurred: there are now distinct regions of nickel-tungsten alloy 1150, tungsten-silicon alloy 1160, and undiffused tungsten 1170. It is also consistent with the conditions that the regions of, *e.g*., nickel and tungsten have a gradation of properties without a discontinuity in the concentrations of the respective metals or a sharp concentration gradient.

### Process for forming nanostructures

The present invention further comprises a process for forming nanostructures. The process comprises first depositing an electrode on a substrate. The substrate, as further described herein, may be a wafer of silicon, and preferably has an insulating coating, such as an oxide, for example SiO2 The electrode functions as an underlayer for the nanostructure, and is made of a conducting material, preferably a metal such as molybdenum, niobium, or tungsten. The method of depositing the electrode can be anyone familiar to one of ordinary skill in the art, but is preferably a method such as electron beam evaporation. The electrode layer is between 10 and 100 nm thick, and is preferably 50 nm thick.

Optionally, a resist is then deposited on the electrode layer. Such a resist is usually used for technologies that utilize lift-off processes for metal depositions. An exemplary resist is a double-layer resist consisting of 10% co-polymer and 2% PMMA resist, that is applied by consecutive spin coating and baking. The resist is then patterned/exposed by a radiation source, such as UV light or an electron beam, to transfer the design into the resist layer.

A catalyst layer, either as a sheet or as dots, is fabricated on the metal substrate or on the resist, where present. Dots of catalyst facilitate controlled growth of individual nanostructures in precise locations. Catalyst dots may be constructed by electron beam lithography. Their dimensions can be controlled using the shot modulation technique. With this technique, catalyst dot sizes can be determined with nanometer precision, and dots as small as 5-10 nm in dimension can be formed. The catalyst layer is not heated during this stage.

On the catalyst layer, layers of other materials are deposited. Such layers include at least one layer of semiconducting material and may include at least one layer of a metal different from the metal of the underlying electrode. The semiconducting material is preferably deposited using an electron beam evaporator. The semiconducting material is preferably amorphous silicon, and the layer has a thickness of 5 - 100 nm, preferably 10 nm.

After the various layers, including one layer of semiconducting material, are deposited a layer of catalyst material is deposited, thereby forming an uppermost layer upon which nanostructures are ultimately fabricated. The catalyst layer is deposited by standard techniques known in the art such as electron beam evaporation or sputtering.

Optionally, if a resist has been applied, it can now be removed by a lift-off process, for example by washing the structures in acetone at 60°C, followed by washing with isopropyl alcohol. After these washings, the structures are rinsed in deionized water and blowdried with nitrogen gas.

Nanostructures can now be grown upon the remaining areas where catalyst layers are exposed. The preferred technique for effecting such growth is plasma-enhanced chemical vapor deposition. As previously described herein, the composition of the vapor will determine the types of nanostructures that are grown. For example, carbon nanotubes can be grown at 5 mbar pressure in a (1:5) mixture of C2H2:NH3 gas. Growth of nanostructures typically occurs at high temperatures, in the range 600 - 1,000°C, such as 700°C. The substrate (with electrode, semiconducting material, and catalyst layers thereon) are brought up to such high temperatures by ramping the temperature up relatively rapidly. Exemplary rates are from 1-10°C/s, preferred rates being in the range 3 - 6°C/s. Such conditions have been referred to in the art as 'annealing', and preferably occur in a vacuum. A low vacuum (*e.g*., 0.05 - 0.5 mbar pressure) suffices. The source gases for the nanostructures are introduced into the chamber when the maximum temperature is reached.

The nanostructures are typically cooled to room temperature before they are permitted to be exposed to air.

Control over individual nanostructure formation is thus achieved because specifically tailored catalyst dots are created, rather than relying on non-uniform break up of a layer of catalyst by prolonged heating prior to nanostructure formation.

### Electron Beam Writer

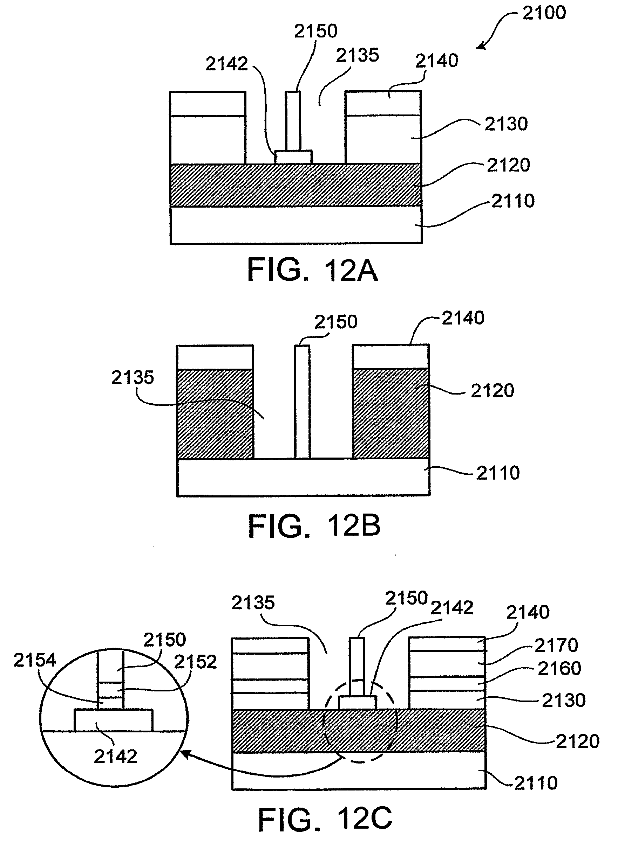

The nanostructures of the present invention may also form the basis of an electron beam writer, as depicted in FIGs. 12-14. A device according to FIGs. 12-14 can find numerous applications where a very fine, focusable beam of electrons is required. For example, it can be used in electron beam lithography to create nanometer scale lines (so called nanolithography). It can also be used in forms of electron microscopy, such as scanning electron microscopy, and in transmission electron microscopy.

FIGs. 12A - 12C show cross-sectional views, viewed sideways, of an electron-beam writing device 2100. Layer 2110 is a wafer, typically of highly doped silicon, which acts as a bottom electrode. Layer 2120 is insulator such as silicon dioxide. Layer 2130 is also insulator such as Si02 which act as sacrificial layer that can be etched away during the manufacturing process of making electron beam writer. Layer 2140 is a top electrode, typically formed from a metal, and often referred to as an actuator electrode. A vertical free-standing nanostructure 2150 resides in a cavity 2135 formed in layers 2130 and 2140. In some embodiments, nanostructure 2150 is disposed on a layer of top electrode metal 2142. In other embodiments, nanostructure 2150 is disposed on the wafer 2110.

The embodiments shown in FIGs. 12A and 12B are of a single electrode stack electron-beam writer. The embodiment in FIG. 12C is of a multi-electrode stack device. In FIG. 12C, layers 2140 and 2160 are metal electrode layers, and layers 2120, 2130 and 2170 are insulating layers all together to form the embodiment for a electron-beam writer. In FIG. 12C, layers 2160 layer act as gate to control the movement of the nanostructure 2150 and layers 2140 layer act as an actuator electrode.

The embodiments described above as shown in FIGs. 12A, 12B and 12C can also be used for making relay switch where layer 2160 act as the gate electrode to control the movement of the nanostructure 2150, the layer 2142 act as the source of the device and the layer 2140 in this example act as the drain of the device to form an embodiment of three terminal device where the nanostructure 2150 can be moved towards the drain layer 2140 by applying electric field at the layer 2160.

The base of nanostructure 2150 is shown in detail in connection with FIG. 12C, though similar principles apply to any of the foregoing embodiments, in FIGs. 12A and 12B. Nanostructure 2150 is separated from metal electrode layer 2142 by a catalyst layer 2152 and an adjacent interface layer 2154. Interface layer 2154 may be a single layer, for example of silicon or germanium, or may comprise multiple adjacent layers. Where layer 2154 comprises multiple adjacent layers, at least one such layer is silicon or germanium; the other layers may be other semiconductors, insulators, or other metals different from the metal of layer 2142, so as to give control over the properties of nanostructure 2150.

Nanostructure 2150 is typically 500 nm-10 µm long from base to tip, and is preferably around 1µm long. The diameter of the nanostructure is typically between 5 nm and 50 nm. Preferably nanostructure 2150 is a carbon nanostructure such as a carbon nanotube or nanofiber.

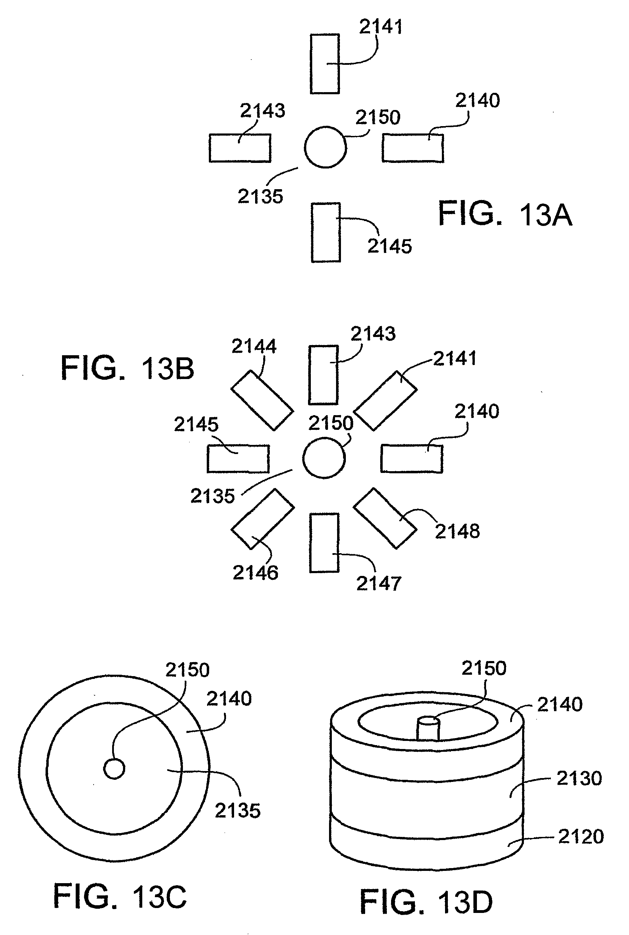

FIGs. 13A - 13C show plan views from the top of various configurations of electrodes situated around a central vertical free-standing nanostructure 2150. In FIGs. 13A and 13B, multiple separately controllable electrodes are envisaged, numbered 2140, 2141, and 2143 - 2148. Exemplary numbers 4 and 8 are shown, though other numbers are possible, depending on the degree of control that is desired of the motion of the nanostructure. For example, other numbers of electrodes include, but are not limited to, 2, 3, 5, 6, 10, 12, and 20.

In FIG. 13C, a single continuous electrode encircles the cavity 2135 in which nanostructure 2150 resides. FIG. 13D shows a perspective view of the embodiment in FIG. 13C.

In operation, a voltage selectively applied to electrodes 2140, etc., can cause the tip of the nanostructure to move in space towards, or away from, a particular electrode, due to the electric field created by the electrodes. According to the disposition of the various electrodes, then, the nanostructure tip can move and therefore point in various directions. The directionality of the tip can therefore be controlled so that electrons, when emitted from the tip in response to a suitable applied voltage, will be caused to move in a desired direction.

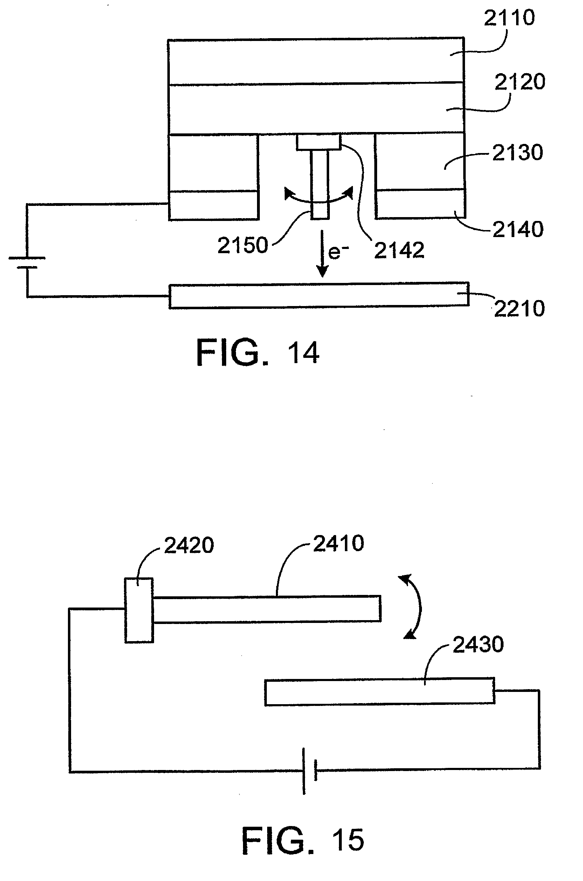

FIG. 14 shows a schematic of an electron-writing device based on a vertically-aligned free-standing nanostructure. The arrow across the nanostructure indicates a degree of freedom of motion within the plane of the figure. A beam of electrons, e-, is shown emanating from the tip of the nanostructure 2150 in the direction of a writing target, or substrate 2310, which also serves as an anode. Also shown in FIG. 14 is a schematic electrical circuit between the anode and the top electrode. In certain embodiments, it is possible to change the direction of the beam direction after it has been emitted from the nanostructures, instead of or in addition to altering the beam direction by causing the nanostructure to tilt in the desired direction. In which case, the direction of the beam after emission can be controlled by an electron optical system (EOS), based on, for example, magnetic lances.

FIG. 15 shows an alternative embodiment in which a nanostructure 2410 is supported horizontally and has at least one degree of freedom, as shown by the arrow, to move in a vertical plane. An electrode 2420 in contact with the nanotubes communicates electrically with anode 2430, which also acts as a writing target.

The electron beam writer described herein may be tailored to various applications by appropriate choices of the various materials. For example, the support wafer 2110, and the insulator disposed thereon 2120 may be varied, as may the choice of metal for the electrodes. The manner of growth of the nanostructure, as further described herein, may permit functionalization of the nanostructure tip, as well as its morphology.

### EXAMPLES

### Example 1: Electron-beam writer

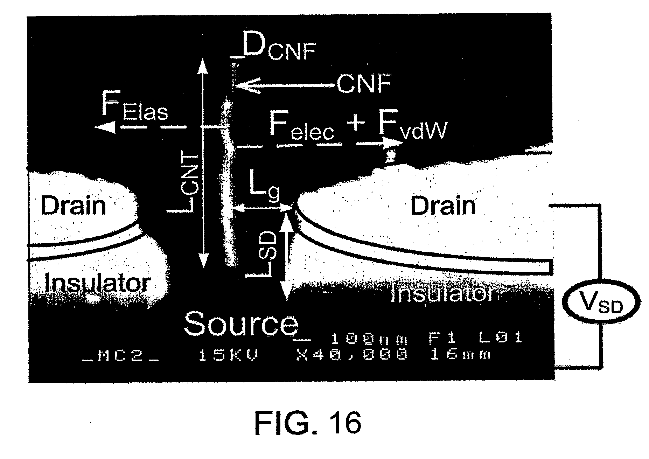

FIG. 16 shows a SEM image of an embodiment of an electron beam writer that may be used as a nano writer, wherein: DCNT = Diameter of CNT/CNF/nano-structure; LSD = thickness of insulator; LCNT = Length of CNT/CNF/nanostructure; Lg = Distance between CNT/CNF/nanostructure and electrodes; FElas = Elastostatic force acting on CNT/CNF/nanostructure; FElec = Electrostatic force; and FvdW = Van der Waals force. The voltage source in FIG. 16 may be DC or AC source depending on application.

The structure in FIG. 16 may also be used as an electron beam emitter for use in a display, wherein the position of the nanostructure is controlled while electrons are emitted from the structure onto, for instance, a fluorescent screen that emits photons when excited by electrons, thus providing a visible point. In this way, a display unit (pixel) with localized geometry control (sub pixels) is provided. By forming a plurality of these display units into a system of electron beam emitters, a display for use as a computer screen or television apparatus may be provided. Even without using the position control, the nano structure may find applicability as a pixel generating device due to the small scale of the complete system.

The structure of FIG. 16 may also be used as a chemical sensor. Super-sensitive chemical sensors can be obtained by functionalization: by functionalizing the tip of the free-standing nanostructure it is possible to attach different kinds of molecules. By actuating the nanostructure by applying a bias (DC/AC depending on requirements) between top electrodes and bottom electrode/electrode N, it is possible to detect a molecule that binds to the tip by measuring the current flow through it.

## Claims

1. An electron beam writer, comprising:
a support;
an insulating layer on the support;
a third layer of material on the insulating layer, arranged to form a cavity;
a metal electrode on the insulating layer, in the cavity;
a nanostructure built upon the metal electrode; and
a first electrode layer deposited on the third layer of material.

2. The electron beam writer according to any one of the preceding claims, wherein said nanostructure is separated from said metal electrode by a catalyst layer and an interface layer.

3. The electron beam writer according to claim 2, wherein said interface layer comprises silicon or germanium.

4. The electron beam writer according to claim 3, wherein said interface layer comprises multiple adjacent layers.

5. The electron beam writer according to any one of the preceding claims, wherein said nanostructure is a vertical free-standing nanostructure

6. The electron beam writer according to any one of the preceding claims, wherein said nanostructure is a cabon nanostructure.

7. The electron beam writer according to any one of the preceding claims, wherein said first electrode layer comprises a plurality of separately controllable electrodes.

8. The electron beam writer according to any one of the claims 1 to 6, wherein said first electrode layer comprises a single continuous electrode encircling said cavity.

9. An electron-writing device comprising:
the electron beam writer according to any one of the preceding claims;
a writing target; and
voltage source connected between the first electrode layer of said electron beam writer and said writing target.

## Patentansprüche

1. Elektronenstrahlschreiber mit:
einem Auflager,
einer Isolationsschicht auf dem Auflager,
einer dritten Materialschicht auf der Isolationsschicht, die ausgelegt ist, einen Hohlraum auszubilden,
einer Metallelektrode auf der Isolationsschicht in dem Hohlraum,
einer Nanostruktur, die auf der Metallelektrode aufgebaut ist, und
einer ersten Elektrodenschicht, die auf der dritten Metallschicht abgeschieden ist.

2. Elektronenstrahlschreiber nach einem der vorhergehenden Ansprüche, wobei die Nanostruktur von der Metallelektrode durch eine Katalysatorschicht und eine Zwischenschicht getrennt ist.

3. Elektronenstrahlschreiber nach Anspruch 2, wobei die Zwischenschicht Silizium oder Germanium enthält.

4. Elektronenstrahlschreiber nach Anspruch 3, wobei die Zwischenschicht eine Anzahl aneinanderliegender Schichten umfasst.

5. Elektronenstrahlschreiber nach einem der vorhergehenden Ansprüche, wobei die Nanostruktur eine vertikal freistehende Nanostruktur ist.

6. Elektronenstrahlschreiber nach einem der vorhergehenden Ansprüche, wobei die Nanostruktur eine Kohlenstoff-Nanostruktur ist.

7. Elektronenstrahlschreiber nach einem der vorhergehenden Ansprüche, wobei die erste Elektrodenschicht mehrere getrennt steuerbare Elektroden umfasst.

8. Elektronenstrahlschreiber nach einem der Ansprüche 1 bis 6, wobei die erste Elektrodenschicht eine einzelne durchgehende Elektrode umfasst, die den Hohlraum einkreist.

9. Elektronenschreibeinrichtung mit:
dem Elektronenstrahlschreiber nach einem der vorhergehenden Ansprüche,
einem Schreib-Zielobjekt und
einer Spannungsquelle, die zwischen der ersten Elektrodenschicht des Elektronenstrahlschreibers und dem Schreib-Zielobjekt geschaltet ist.

## Revendications

1. Dispositif d'écriture de faisceau d'électrons, comprenant :
un support ;
une couche isolante sur le support ;
une troisième couche de matériau sur la couche isolante, agencée pour former une cavité ;
une électrode métallique sur la couche isolante, dans la cavité ;
une nanostructure construite sur l'électrode métallique ; et
une première couche d'électrode déposée sur la troisième couche de matériau.

2. Dispositif d'écriture de faisceau d'électrons selon l'une quelconque des revendications précédentes, dans lequel ladite nanostructure est séparée de ladite électrode métallique par une couche de catalyseur et une couche d'interface.

3. Dispositif d'écriture de faisceau d'électrons selon la revendication 2, dans lequel ladite couche d'interface comprend du silicium ou du germanium.

4. Dispositif d'écriture de faisceau d'électrons selon la revendication 3, dans lequel ladite couche d'interface comprend plusieurs couches adjacentes.

5. Dispositif d'écriture de faisceau d'électrons selon l'une quelconque des revendications précédentes, dans lequel ladite nanostructure est une nanostructure autonome verticale.

6. Dispositif d'écriture de faisceau d'électrons selon l'une quelconque des revendications précédentes, dans lequel ladite nanostructure est une nanostructure de carbone.

7. Dispositif d'écriture de faisceau d'électrons selon l'une quelconque des revendications précédentes, dans lequel ladite première couche d'électrode comprend une pluralité d'électrodes pouvant être commandées séparément.

8. Dispositif d'écriture de faisceau d'électrons selon l'une quelconque des revendications 1 à 6, dans lequel ladite première couche d'électrode comprend une électrode continue unique encerclant ladite cavité.

9. Dispositif d'écriture d'électrons comprenant :
le dispositif d'écriture de faisceau d'électrons selon l'une quelconque des revendications précédentes ;
une cible d'écriture ; et
une source de tension reliée entre la première couche d'électrode dudit dispositif d'écriture de faisceau d'électrode et ladite cible d'écriture.
